# EUROPEAN PATENT APPLICATION

(11) **EP 4 823 252 A1**
(43) Date of publication of application: **14.10.2026**
(21) Application number: 25865134.8
(22) Date of filing: 19.08.2025
(51) Int. Cl.: H05K 5/02

(54) **CRUISE APPARATUS OF AUTONOMOUS MOBILE DEVICE, AND AUTONOMOUS MOBILE DEVICE**

(30) Priority: 13.09.2024 CN 202422259709 U; 30.05.2025 CN 202521095784 U
(71) Applicant: Shenzhen Hanyang Technology Co., Ltd., Shenzhen, Guangdong 518000 (CN)
(72) Inventor: HUANG, Yang, Shenzhen, Guangdong 518000 (CN); ZHU, Taotao, Shenzhen, Guangdong 518000 (CN); SONG, Yongqi, Shenzhen, Guangdong 518000 (CN); WU, Longsheng, Shenzhen, Guangdong 518000 (CN)
(74) Representative: Abel & Imray LLP
(86) International application number: PCT/CN2025/115535
(87) International publication number: WO 2026/056635

(57) **Abstract**

The present application relates to navigation apparatuses, in particular to a navigation apparatus for an autonomous mobile device, and an autonomous mobile device, which are used to solve the technical problems that an existing navigation apparatus is complicated in operation and thus affects maintenance efficiency because a main body housing needs to be dismounted during overhauling of a module, and moreover, a sealing structure is complicated, prone to aging and difficult to keep a waterproof effect of a camera module for a long time. The navigation apparatus of the autonomous mobile device comprises a navigation housing, a housing mounting plate and a lateral clamping block, wherein the housing mounting plate implements a transition connection between the navigation housing and a main body housing, positioning posts are combined with positioning holes to form a stable connection, the lateral clamping block provides a lateral clamping force to improve the sealing performance and secure the structure, so the navigation housing can be removed simply by removing the connecting member between the navigation housing and the housing mounting plate, without disassembling the main body housing. The present application enables convenient mounting, removal and maintenance of the navigation apparatus while ensuring sealing performance.

## Description

### TECHNICAL FIELD

The present application relates to navigation apparatuses, in particular to a navigation apparatus for an autonomous mobile device, and an autonomous mobile device.

### BACKGROUND

A navigation apparatus refers to an intelligent navigation system integrating at least one selected from a communication module, a camera module, a voice module, and an illumination module, a voice module or an illumination module and is configured to implement functions such as navigation and positioning, environmental perception, data acquisition and control feedback of an autonomous mobile device (such as a snow removal robot and a leaf blowing robot).

In an existing navigation apparatus, for improving sealing performance, a housing connection interface is usually arranged inside the main body housing, and structures such as a sealing ring and a waterproof cover are adopted for protection. However, this design requires the main body housing to be disassembled during maintenance or servicing of a module, resulting in complicated operation and reduced maintenance efficiency. In addition, the sealing structure is complicated and prone to aging, making it difficult to maintain waterproof performance for a long time. In outdoor environments such as rain or snow, water ingress is likely to damage the camera module, thereby affecting service life and recognition performance.

### SUMMARY

Embodiments of the present application aim to provide a navigation apparatus for an autonomous mobile device, and an autonomous mobile device, which can solve the technical problems that an existing navigation apparatus is complicated in operation and affects maintenance efficiency because a main body housing needs to be dismounted during overhauling of a module, and moreover, a sealing structure is complicated, prone to aging and difficult to keep a waterproof effect of a camera module for a long time.

A navigation apparatus for an autonomous mobile device comprises a navigation housing; and
the navigation apparatus is characterized by further comprising a housing mounting plate and a lateral clamping block.

The housing mounting plate comprises a first mounting plate fixed to a bottom surface of the navigation housing, and a second mounting plate connected to the first mounting plate and configured to be fixed to a main body housing; a plurality of positioning posts are arranged on a top surface of the first mounting plate, and a plurality of positioning holes respectively matching the plurality of positioning posts are formed in the bottom surface of the navigation housing; and
a side of the lateral clamping block is configured to be fixed to the main body housing, and the opposite side is connected to a side wall of the navigation housing.

Optionally, the second mounting plate is configured to attach to a side wall of the main body housing, and the first mounting plate is arranged horizontally.

Optionally, the first mounting plate and the second mounting plate are perpendicular to each other and are integrally formed.

Optionally, an included angle between each positioning post and the top surface of the first mounting plate is in a range from 80° to 90°, or 60° to 75°.

Optionally, an included angle between each positioning post and the top surface of the first mounting plate is 90°.

Optionally, a side of the lateral clamping block is configured to be fixed to the main body housing, and an opposite side is provided with a protrusion or a convex lug structure which is configured to be inserted into or pressed against an engagement groove of the navigation housing.

Optionally, the navigation apparatus further comprises a plurality of modules arranged in an inner cavity of the navigation housing; and
wiring through-holes communicating with the inner cavity of the navigation housing are formed in the navigation housing, connectors are arranged in the wiring through-holes, a seal is formed between a side wall of each connector and a wall of the corresponding wiring through-hole, a first end of each connector located in the inner cavity of the navigation housing is connected to the plurality of modules, and a second end of each connector located outside the navigation housing is configured to be connected to a main control board of the autonomous mobile device.

Optionally, one of the plurality of modules is a camera module, and the camera module comprises a camera assembly board, a camera mounting bracket and a camera mounting base;
a camera is arranged on the camera assembly board; the camera mounting bracket comprises a first enclosing wall which defines a first mounting space; the camera mounting base comprises a second enclosing wall which defines a second mounting space; and the camera mounting bracket is arranged in the second mounting space, and the camera is arranged in the first mounting space.

Optionally, one end of the camera mounting base is coupled to a camera opening formed in the navigation housing, the camera assembly board is provided at the other end of the camera mounting base, and the camera assembly board seals the second mounting space; and the camera mounting bracket is located in the second mounting space and fixed to the camera assembly board to seal the first mounting space, and the camera is located in the first mounting space.

Optionally, the camera module further comprises a camera waterproof block fitted over an end portion of the camera 514 distal from the camera assembly board.

Optionally, an end of the camera mounting bracket adjacent to the camera opening is provided with a camera lens cover, and the camera lens cover is fixed to an inner wall of the camera mounting base.

Optionally, the camera module further comprises a heating film, and the heating film is fixed to the camera mounting base and located on a side of the camera lens cover facing the camera.

Optionally, the camera module further comprises a heat sink arranged on a side of the camera assembly board opposite from the camera.

Optionally, a top surface of the navigation housing comprises a first inclined surface, a second inclined surface and a third inclined surface which are connected in sequence in a direction away from the lateral clamping block 40 and have inclination angles that progressively increase.

Optionally, an inclination angle of the first inclined surface is ≥5°, an inclination angle of the third inclined surface is ≤30°, and differences in inclination angle between the first inclined surface and the second inclined surface, and between the second inclined surface and the third inclined surface, are each in a range from 5° to 15°.

Optionally, the plurality of modules further comprise at least one selected from a communication module, a voice module, and an illumination module.

Meanwhile, the present application further provides an autonomous mobile device, characterized by comprising: a main body housing and at least one above navigation apparatus of the autonomous mobile device arranged on the main body housing.

Optionally, two navigation apparatuses are provided, and the two navigation apparatuses are symmetrically arranged on two sides of the main body housing.

Optionally, at least one handle protrudes from a side wall of the main body housing 10, and the navigation apparatus is arranged on the corresponding handle.

Compared with the prior art, the present application has the following beneficial effects.
(1) The navigation apparatus comprises the navigation housing, the housing mounting plate and the lateral clamping block. The housing mounting plate provides an intermediate connection between the navigation housing and the main body housing, the positioning posts cooperate with the positioning holes to form a stable connection, and the lateral clamping block provides a lateral clamping force to improve sealing performance and secure the structure. Therefore, the navigation housing can be removed simply by removing the connecting members between the navigation housing and the housing mounting plate, without disassembling the main body housing. Accordingly, convenient mounting, removal and maintenance of the navigation apparatus can be achieved while ensuring sealing performance.
(2) In the present application, the camera module is located in the inner cavity of the navigation housing. In addition, the camera assembly board carrying the camera can be mounted in a sealed manner by means of the first mounting space of the camera mounting bracket and the second mounting space of the camera mounting base, thereby improving waterproof performance.

### BRIEF DESCRIPTION OF THE DRAWINGS

FIG. 1 is a schematic axonometric structural diagram of an embodiment of an autonomous mobile device in the present application (not showing a lower half portion of a main body housing).
FIG. 2 is a first schematic structural diagram of an embodiment of a navigation apparatus for an autonomous mobile device in the present application.
FIG. 3 is a second schematic structural diagram of an embodiment of the present application (not showing a lateral clamping block).
FIG. 4 is an exploded view of a navigation apparatus in an embodiment of the present application.
FIG. 5 is a schematic structural diagram of a first shell in an embodiment of the present application.
FIG. 6 is a schematic structural diagram of a second shell in an embodiment of the present application.
FIG. 7 is a schematic structural diagram of arranging a housing mounting plate and a lateral clamping block on a main body housing in an embodiment of the present application.
FIG. 8 is an exploded view of a camera module in an embodiment of the present application.

Description of reference numerals: 10, main body housing; 11, handle; 20, navigation housing; 21, first shell; 22, second shell; 231, first inclined surface; 232, second inclined surface; 233, third inclined surface; 24, antenna opening; 25, camera opening; 26, fill light opening; 27, microphone opening; 28, wiring through-hole; 29, engagement groove; 30, housing mounting plate; 31, the first mounting plate; 311, positioning post; 32, second mounting plate; 40, lateral clamping block; 51, camera module; 511, camera assembly board; 512, camera mounting bracket; 513, camera mounting base; 514, camera; 515, camera waterproof block; 516, camera lens cover; 517, heating film; 5171, heating film voltage wiring harness; 518, heat sink; 52, voice module; 53, illumination module; 54, antenna component; and 60, connector.

### DETAILED DESCRIPTION

The present application is further described below with reference to the accompanying drawings and specific embodiments.

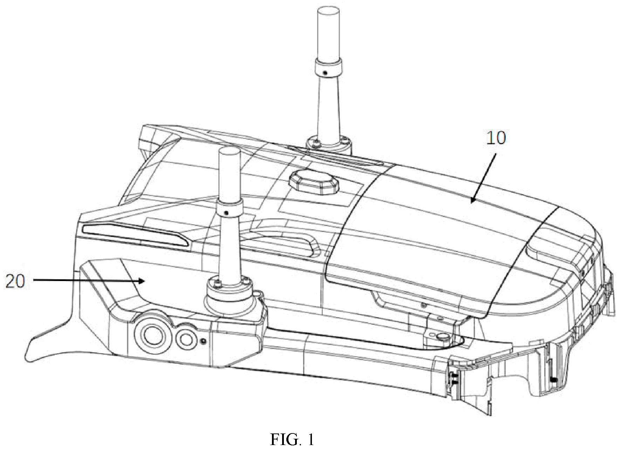

Referring to FIG. 1, the present embodiment provides an autonomous mobile device, comprising a main body housing 10 and at least one navigation apparatus for an autonomous mobile device arranged on the main body housing 10. In the present embodiment, two navigation apparatuses of the autonomous mobile device are symmetrically arranged on two sides of the main body housing 10. In other embodiments, only one navigation apparatus or more navigation apparatuses may be arranged.

It can be understood that the above autonomous mobile device refers to a device capable of autonomously or semi-autonomously moving without being pulled by an external traction source and may be an engineering device, such as a tracked robot or an automatic compactor; a service or patrol robot, such as a security/patrol tracked platform; or an agricultural robot, such as a sowing robot.

A plurality of handles 11 may be arranged on a side wall of the main body housing 10. In the present embodiment, two handles 11 are provided, and the handles 11 are configured to be held by an operator when transferring the autonomous mobile device.

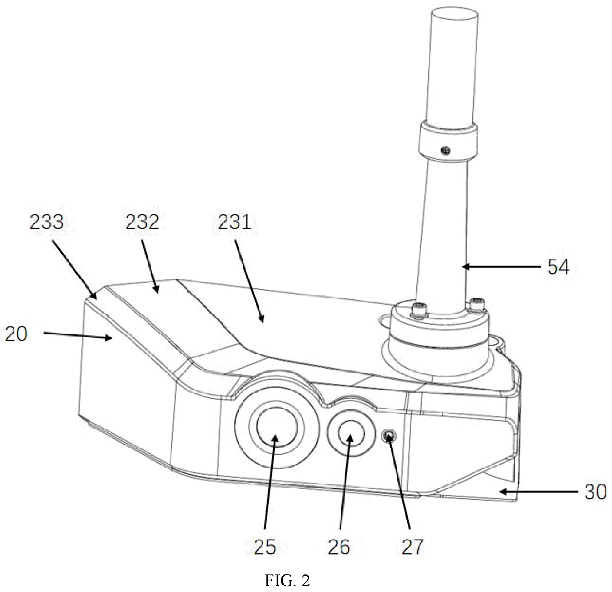

Referring to FIG. 2 to FIG. 8, the above navigation apparatus comprises a navigation housing 20, a housing mounting plate 30 and a lateral clamping block 40. The housing mounting plate 30 comprises a first mounting plate 31 fixed to a bottom surface of the navigation housing 20, and a second mounting plate 32 connected to the first mounting plate 31 and configured to be fixed to a main body housing 10; a plurality of positioning posts 311 are arranged on a top surface of the first mounting plate 31, and a plurality of positioning holes respectively matching the plurality of positioning posts 311 are formed in the bottom surface of the navigation housing 20; and a side of the lateral clamping block 40 is configured to be fixed to the main body housing 10, and an opposite side of the lateral clamping block 40 is connected to a side wall of the navigation housing 20.

The navigation housing 20 has a split structure. An inner cavity of the navigation housing 20 is configured to accommodate various modules, and openings matching the respective modules, such as an antenna opening 24, a camera opening 25, a fill light opening 26, and a microphone opening 27, are formed in a wall of the navigation housing 20. The first mounting plate 31 is connected to the navigation housing 20 and carries the positioning posts 311, thereby forming an insertion-and-positioning platform. The second mounting plate 32 is configured to be connected to the main body housing 10 and serves to fix the navigation housing 20. The positioning posts 311 and the positioning holes enable rapid alignment and stable mounting between the navigation housing 20 and the housing mounting plate 30, thereby preventing rotation or misalignment. Specifically, three positioning posts 311 and three positioning holes are formed. The lateral clamping block 40 is connected to the main body housing 10 and the side wall of the navigation housing 20 to generate a lateral clamping force, so as to press an edge of the navigation housing 20, thereby improving sealing performance and inhibiting shaking or loosening. Specifically, the lateral clamping block 40 may be arranged on the main body housing 10, so that the side wall of the navigation housing 20 engages with the lateral clamping block 40. Alternatively, the lateral clamping block 40 may be arranged on the side wall of the navigation housing 20, so that the main body housing 10 engages with the lateral clamping block 40.

A principle of the present embodiment is as follows.

During mounting, the housing mounting plate 30, in particular the second mounting plate 32, and the lateral clamping block 40 are first mounted to the main body housing 10. Then, the positioning holes in the bottom surface of the navigation housing 20 are aligned with the positioning posts 311 on the housing mounting plate 30, so that insertion and alignment are completed. Meanwhile, the lateral clamping block 40 engages with the side wall of the navigation housing 20. Thereafter, a plurality of connecting members, such as screws, are inserted from the bottom surface of the first mounting plate 31 to fix the housing mounting plate 30 to the navigation housing 20, thereby completing mounting. During removal, the connecting members on the bottom surface of the first mounting plate 31 are removed, so that the navigation housing 20 can be lifted away for quick removal.

Alternatively, during mounting, the housing mounting plate 30, in particular the second mounting plate 32, is first mounted to the main body housing 10. Then, the positioning holes in the bottom surface of the navigation housing 20 are aligned with the positioning posts 311 on the housing mounting plate 30, so that insertion and alignment are completed. Meanwhile, the lateral clamping block 40 engages with the main body housing 10. Thereafter, the connecting members, such as screws, are inserted from the bottom surface of the first mounting plate 31 to fix the housing mounting plate 30 to the navigation housing 20, thereby completing mounting. During removal, the connecting members on the bottom surface of the first mounting plate 31 are removed, so that the navigation housing 20 can be lifted away for quick removal.

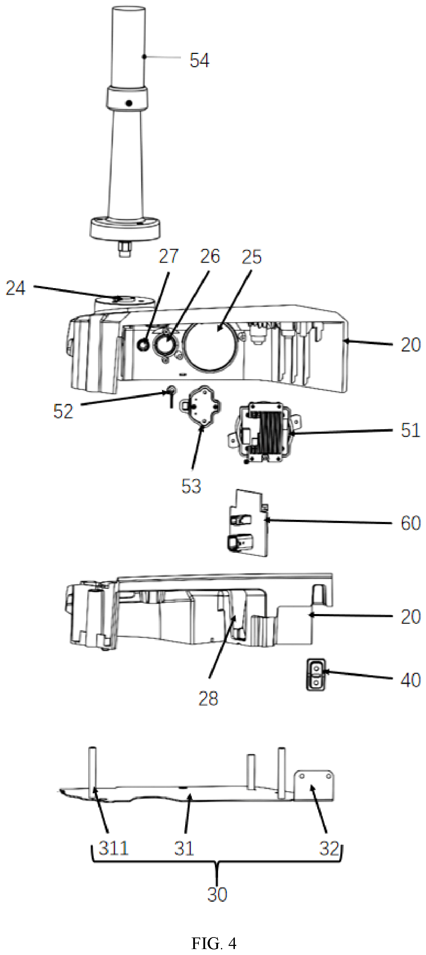

In some embodiments, referring to FIG. 4, a plurality of modules are arranged in the inner cavity of the navigation housing 20. Specifically, a communication module, a camera module 51, a voice module 52 and an illumination module 53 are arranged in the inner cavity of the navigation housing 20, and only two or three of these modules may be included in other embodiments.

It can be understood that the communication module is a component for implementing data transmission and information exchange between the autonomous mobile device and an external terminal and supports a wireless or wired communication protocol. The communication module in the present embodiment comprises an antenna component 54. The camera module 51 is an image acquisition unit for shooting an environmental image or a video around the autonomous mobile device and implementing a visual perception function in combination with an image processing algorithm, such as a visible light camera, an infrared camera, a depth camera, etc. The voice module 52 is a human-machine interface module for voice interaction, and may include functions such as voice recognition, speech synthesis, and audio playback, for example, a microphone array, a loudspeaker, and a DSP audio processor. The illumination module 53 is a light source apparatus for environmental illumination or auxiliary visual perception, for example, an LED light and its control circuit, etc.

Wiring through-holes 28 communicating with the inner cavity of the navigation housing 20 are formed in the navigation housing 20, connectors 60 are arranged in the wiring through-holes 28, and a seal is formed between a side wall of each connector 60 and a wall of the corresponding wiring through-hole 28. A first end of each connector 60 located in the inner cavity of the navigation housing 20 is connected to the plurality of modules, and a second end of each connector 60 located outside the navigation housing 20 is configured to be connected to a main control board of the autonomous mobile device. The main control board refers to a core circuit board, in the autonomous mobile device, for controlling, scheduling, computing and communication.

It can be understood that the communication module, the camera module 51, the voice module 52 and the illumination module 53 need to be guided out to interface ports of the main control board of the autonomous mobile device respectively through wires so as to implement communication and control. Specifically, a function-integration control board (not shown in FIG. 4) is arranged in the inner cavity of the navigation housing 20. The communication module, the camera module 51, the voice module 52 and the illumination module 53 are respectively connected to the function-integration control board through wires, and are connected to first ends of the connectors 60 located in the inner cavity of the navigation housing 20 via a shielded bundled bus. Interface ports of the main control board of the autonomous mobile device are connected to second ends of the connectors 60 located outside the navigation housing 20, so that unified communication and control are implemented.

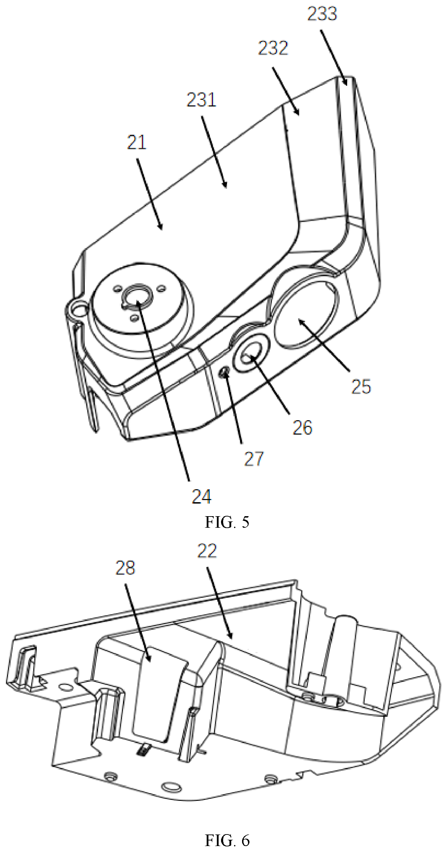

In some embodiments, referring to FIG. 5 and FIG. 6, the navigation housing 20 comprises a first shell 21 and a second shell 22, the first shell 21 forms a top surface and an outer side wall of the navigation housing 20, the second shell 22 forms the bottom surface and an inner side wall of the navigation housing 20, and the inner cavity of the navigation housing 20 is formed between the first shell 21 and the second shell 22. The communication module, the camera module 51, the illumination module 53 and the voice module 52 may be arranged in the inner cavity of the navigation housing 20, and the antenna opening 24, the camera opening 25, the fill light opening 26 and the microphone opening 27 respectively corresponding to the communication module, the camera module 51, the illumination module 53 and the voice module 52 are formed in the first shell 21.

In some embodiments, referring to FIG. 2 to FIG. 4, and FIG. 7, the second mounting plate 32 is configured to attach to a side wall of the main body housing 10, and the first mounting plate 31 is arranged horizontally.

The first mounting plate 31 and the second mounting plate 32 may be integrally formed, which facilitates manufacturing and provides high structural strength. The first mounting plate 31 and the second mounting plate 32 may be connected through a connecting member to form an adjustable or dismountable structure so as to adapt to different structural deviations. For example, the first mounting plate 31 and the second mounting plate 32 are connected through a metal hinge, a positioning gear disc is arranged between the first mounting plate 31 and the second mounting plate 32, and then the first mounting plate and the second mounting plate are locked through a screw after an angle is adjusted. Alternatively, an arc-shaped guide groove is formed between the first mounting plate 31 and the second mounting plate 32, the first mounting plate 31 is slidable along the arc-shaped guide groove by means of a screw, an angle is changed, and then the screw is tightened.

In some embodiments, referring to FIG. 2, FIG. 3 and FIG. 7, the first mounting plate 31 and the second mounting plate 32 are perpendicular to each other and are integrally formed. In the present embodiment, the second mounting plate 32 is configured to attach to a side wall of the main body housing 10, the first mounting plate 31 is arranged horizontally, first mounting plate 31 and the second mounting plate 32 form an L-shaped structure, which provides improved support rigidity.

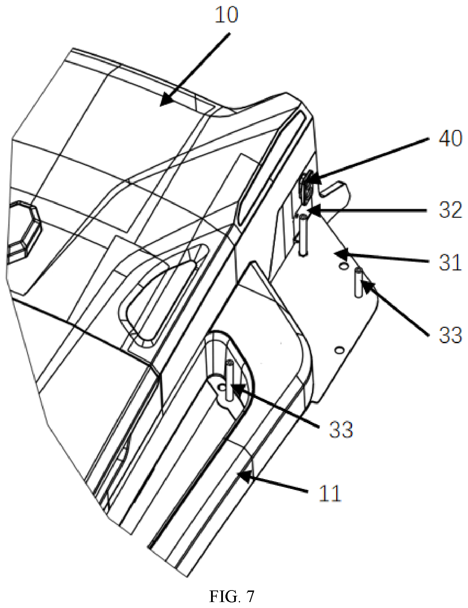

In some embodiments, referring to FIG. 4 and FIG. 7, an included angle between each positioning post 311 and the top surface of the first mounting plate 31 is in a range from 80° to 90°, or 60° to 75°.

An included angle between each positioning post 311 and the top surface of the first mounting plate 31 in a range from 80° to 90° can enable vertical insertion and withdrawal and gravity-assisted positioning.

However, when the mounting space or the mounting/removal direction is limited, the included angle between each positioning post 311 and the top surface of the first mounting plate 31 may be in a range from 60° to 75°, for use in combination with a sliding guide ramp and a locking latch.

In some embodiments, when the included angle between each positioning post 311 and the top surface of the first mounting plate 31 is 90°, the structure has the highest stability, high pull-out resistance, and a simple configuration.

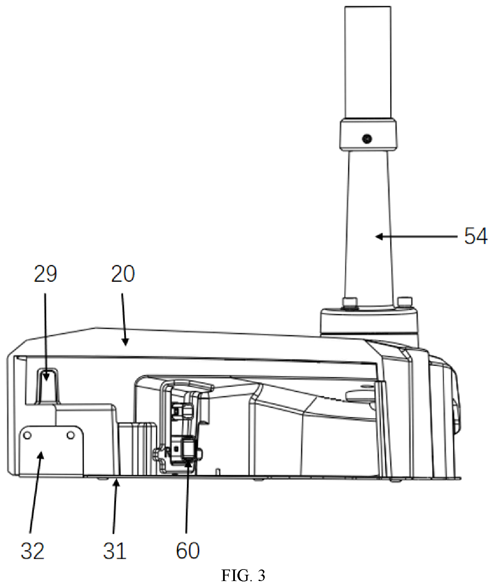

In some embodiments, referring to FIGS. 4 and 7, the lateral clamping block 40 is configured as a clamping block. a side of the lateral clamping block 40 is configured to be fixed to the main body housing 10, and an opposite side thereof engages with an engagement groove 29 formed in the side wall of the navigation housing 20. Specifically, the side of the lateral clamping block 40 for engagement is provided with a protrusion or lug configured to be inserted into or pressed against the engagement groove 29 of the navigation housing 20, as shown in FIG. 3.

In other embodiments, the lateral clamping block 40 may be an elastic protruding hook arranged on the side wall of the navigation housing 20 and configured to be clamped to and locked into a locking groove formed in the main body housing 10.

In some embodiments, referring to FIG. 2 and FIG. 5, the top surface of the navigation housing 20 comprises a first inclined surface 231, a second inclined surface 232 and a third inclined surface 233 which are connected in sequence in a direction away from the lateral clamping block 40 and have inclination angles that progressively increase. Specifically, the first inclined surface 231, the second inclined surface 232 and the third inclined surface 233 are arranged on a top surface of the first shell 21.

The three continuous inclined surfaces allow rainwater or accumulated snow to slide off naturally, prevent water ingress into the navigation housing 20, facilitate removal of dust and fallen leaves, and reduce cleaning frequency.

In some embodiments, in view of the fact that an excessively large inclination angle may affect the height of the center of gravity of the device, whereas an insufficient progressive increase in inclination angle may result in insignificant improvement in airflow, the inclination angle of the first inclined surface 231 is ≥5°, the inclination angle of the third inclined surface 233 is ≤30°, and differences in inclination angle between the first inclined surface 231 and the second inclined surface 232, and between the second inclined surface 232 and the third inclined surface 233, may each be in a range from 5° to 15°. For example, inclination angles of the first inclined surface 231, the second inclined surface 232 and the third inclined surface 233 may be respectively 5°, 10° and 20°, or 8°, 15° and 25°, or 10°, 18°, and 30°.

In some embodiments, the camera module 51 is arranged in the inner cavity of the navigation housing 20, and the camera module 51 comprises a camera assembly board 511, a camera mounting bracket 512 and a camera mounting base 513.

A camera 514 is arranged on the camera assembly board 511.

The camera mounting bracket 512 comprises a first enclosing wall defining a first mounting space. The camera mounting base 513 comprises a second enclosing wall defining a second mounting space.

The camera mounting bracket 512 is arranged in the second mounting space, and the camera 514 is arranged in the first mounting space.

The camera assembly board 511 may have a plate-like structure, and the camera 514 may be arranged on a board surface. The camera 514 refers to a camera device having only one lens and mainly comprises a lens, an image sensor, an image processing chip and other key components. An operating principle of the camera 514 mainly includes optical imaging and image processing. During optical imaging, the lens focuses light from a target object onto the image sensor to form a set of pixels. During image processing, the image sensor converts the light into electrical signals, and the image processing chip processes the electrical signals to obtain a clear image. The camera mounting bracket 512 may be defined by the first enclosing wall, and the first mounting space may be a hollow space formed inside the camera mounting bracket 512. The camera mounting base 513 may be defined by the second enclosing wall, and the second mounting space may be a hollow space formed inside the camera mounting base 513.

In the present embodiment, through the first mounting space of the camera mounting bracket 512 and the second mounting space of the camera mounting base 513, the camera assembly board 511 may be mounted in a sealed mode, so the waterproof effect is improved, and meanwhile, the camera module 51 is arranged in the inner cavity of the navigation housing 20, so the waterproof effect is further improved.

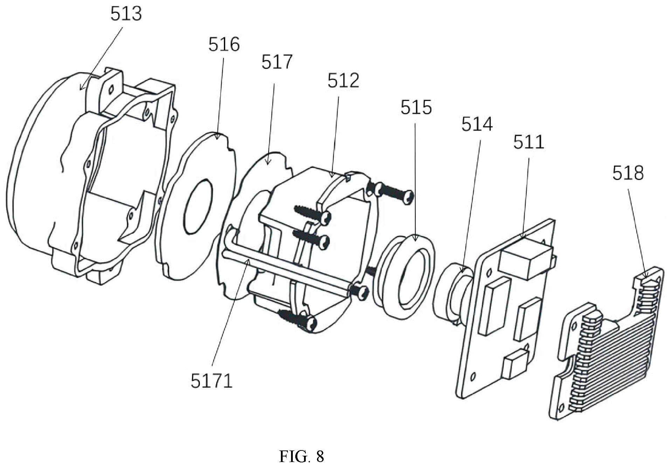

As shown in FIG. 8, in an embodiment, one end of the camera mounting base 513 is coupled to a camera opening 25 formed in the navigation housing 20, and the camera assembly board 511 is provided at the other end of the camera mounting base 513, and the camera assembly board 511 seals the second mounting space; and the camera mounting bracket 512 is located in the second mounting space and fixed to the camera assembly board 511 to seal the first mounting space, and the camera 514 is located in the first mounting space.

As shown in FIG. 8, in an embodiment, the camera module 51 further comprises a camera waterproof block 515 fitted over an end portion of the camera 514 distal from the camera assembly board 511. The material of the camera waterproof block 515 may be selected according to functional requirements, such that the camera waterproof block 515 provides waterproofing without damaging the camera 514. For example, a silicone material may be used. A through-hole is formed in a middle region of the camera waterproof block 515, so that after the camera waterproof block 515 is fitted over the camera 514, waterproofing is achieved without affecting normal operation of the camera 514.

As shown in FIG. 8, in an embodiment, an end of the camera mounting bracket 512 adjacent to the camera opening 25 is provided with a camera lens cover 516, and the camera lens cover 516 is fixed to an inner wall of the camera mounting base 513.

The camera lens cover 516 may be made of a transparent material, such as acrylic or glass, and is arranged in front of the camera 514, thereby protecting optical elements in the camera 514, preventing impurities such as dust and water from entering the lens, and avoiding adverse influence on the recognition function of the camera 514.

As shown in FIG. 8, in an embodiment, the camera module 51 further comprises a heating film 517, and the heating film 517 is fixed to the camera mounting base 513 and located on a side of the camera lens cover 516 facing the camera 514 or on a side of the camera lens cover 516 opposite from the camera 514.

A voltage wiring harness 5171 for the heating film is connected to an external power source to supply voltage to the heating film 517, thereby increasing the temperature of the heating film 517 and melting snow accumulated on the camera module 51. In order to prevent the heating film 517 from being prone to damage, the heating film 517 may be preferably arranged on the side of the camera lens cover 516 close to the camera 514.

In the present embodiment, a temperature of the camera lens cover 516 is increased through the heating film 517, so that the snow accumulated on the camera lens cover 516 is cleared away, and a recognition effect of the camera 514 is improved.

As shown in FIG. 8, in an embodiment, the camera module 51 further comprises a heat sink 518 arranged on the camera assembly board 511, and the heat sink 518 is located on a side of the camera assembly board 511 opposite from the camera 514, namely, located on an outer side.

The heat sink 518 may have a plate-like structure, and a surface of the heat sink 518 facing away from the camera assembly board 511 may be provided with heat dissipation grooves.

In the present embodiment, a design structure of the heat sink 518 corresponds to the camera assembly board 511, so that a heat dissipation effect can be improved. In addition, the heat dissipation grooves increase the surface area on the back side of the heat sink 518, allowing the surface area to directly contact air, thereby dissipating heat to the surrounding environment more effectively and significantly improving heat dissipation efficiency. The heat dissipation grooves can also guide airflow, so that air forms a more tortuous flow path when flowing through the heat sink 518, increasing contact time and contact area between the air and the heat sink 518, and further improving heat dissipation.

The above embodiments are merely used to describe the technical solutions of the present application, and are not intended to limit the present application. Those ordinarily skilled in the art can modify specific technical solutions recorded in the above embodiments, or make equivalent replacement to some technical features of them. These modifications or replacements do not make essence of the corresponding technical solutions depart from the scope of the technical solutions protected by the present invention.

## Claims

1. A navigation apparatus for an autonomous mobile device, comprising a navigation housing (20);
wherein the navigation apparatus further comprises a housing mounting plate (30) and a lateral clamping block (40);
the housing mounting plate (30) comprises a first mounting plate (31) fixed to a bottom surface of the navigation housing (20), and a second mounting plate (32) connected to the first mounting plate (31) and configured to be fixed to a main body housing (10); a plurality of positioning posts (311) are arranged on a top surface of the first mounting plate (31), and a plurality of positioning holes respectively matching the plurality of positioning posts (311) are formed in the bottom surface of the navigation housing (20); and
a side of the lateral clamping block (40) is configured to be fixed to the main body housing (10), and the opposite side is connected to a side wall of the navigation housing (20).

2. The navigation apparatus of the autonomous mobile device according to claim 1, wherein
the second mounting plate (32) is configured to fit against a side wall of the main body housing (10), and the first mounting plate (31) is arranged horizontally.

3. The navigation apparatus of the autonomous mobile device according to claim 2, wherein
the first mounting plate (31) and the second mounting plate (32) are perpendicular to each other and are integrally formed.

4. The navigation apparatus of the autonomous mobile device according to any one of claims 1 to 3, wherein
an included angle between each positioning post (311) and the top surface of the first mounting plate (31) is in a range from 80° to 90°, or 60° to 75°.

5. The navigation apparatus of the autonomous mobile device according to claim 4, wherein
an included angle between each positioning post (311) and the top surface of the first mounting plate (31) is 90°.

6. The navigation apparatus of the autonomous mobile device according to claim 5, wherein
a side of the lateral clamping block (40) is configured to be fixed to the main body housing (10), and an opposite side is provided with a protrusion or a convex lug structure which is configured to be inserted into or pressed against an engagement groove (29) of the navigation housing (20).

7. The navigation apparatus of the autonomous mobile device according to claim 5, wherein
the navigation apparatus further comprises a plurality of modules arranged in an inner cavity of the navigation housing (20); and
wiring through-holes (28) communicating with the inner cavity of the navigation housing (20) are formed in the navigation housing (20), connectors (60) are arranged in the wiring through-holes (28), a seal is formed between a side wall of each connector (60) and a wall of the corresponding wiring through-hole (28), a first end of each connector (60) located in the inner cavity of the navigation housing (20) is connected to the plurality of modules, and a second end of each connector (60) located outside the navigation housing (20) is configured to be connected to a main control board of the autonomous mobile device.

8. The navigation apparatus of the autonomous mobile device according to claim 7, wherein
one of the plurality of modules is a camera module (51), and the camera module (51) comprises a camera assembly board (511), a camera mounting bracket (512) and a camera mounting base (513);
a camera (514) is arranged on the camera assembly board (511); the camera mounting bracket (512) comprises a first enclosing wall which defines a first mounting space; the camera mounting base (513) comprises a second enclosing wall which defines a second mounting space; and the camera mounting bracket (512) is arranged in the second mounting space, and the camera (514) is arranged in the first mounting space.

9. The navigation apparatus of the autonomous mobile device according to claim 8, wherein
one end of the camera mounting base (513) is coupled to a camera opening (25) formed in the navigation housing (20), the camera assembly board (511) is provided at the other end of the camera mounting base (513), and the camera assembly board (511) seals the second mounting space; and the camera mounting bracket (512) is located in the second mounting space and fixed to the camera assembly board (511) to seal the first mounting space, and the camera (514) is located in the first mounting space.

10. The navigation apparatus of the autonomous mobile device according to claim 9, wherein
the camera module (51) further comprises a camera waterproof block (515) fitted over an end portion of the camera (514) distal from the camera assembly board (511).

11. The navigation apparatus of the autonomous mobile device according to claim 9, wherein
an end of the camera mounting bracket (512) adjacent to the camera opening (25) is provided with a camera lens cover (516), and the camera lens cover (516) is fixed to an inner wall of the camera mounting base (513).

12. The navigation apparatus of the autonomous mobile device according to claim 11, wherein
the camera module (51) further comprises a heating film (517), and the heating film (517) is fixed to the camera mounting base (513) and located on a side of the camera lens cover (516) facing the camera (514).

13. The navigation apparatus of the autonomous mobile device according to claim 9, wherein
the camera module (51) further comprises a heat sink (518) arranged on a side of the camera assembly board (511) opposite from the camera (514).

14. The navigation apparatus of the autonomous mobile device according to claim 1, wherein
a top surface of the navigation housing (20) comprises a first inclined surface (231), a second inclined surface (232) and a third inclined surface (233) which are connected in sequence in a direction away from the lateral clamping block (40) and have inclination angles that progressively increase.

15. The navigation apparatus of the autonomous mobile device according to claim 14, wherein
an inclination angle of the first inclined surface (231) is ≥5°, an inclination angle of the third inclined surface (233) is ≤30°, and differences in inclination angle between the first inclined surface (231) and the second inclined surface (232), and between the second inclined surface (232) and the third inclined surface (233), are each in a range from 5° to 15°.

16. The navigation apparatus of the autonomous mobile device according to claim 8, wherein
the plurality of modules further comprise at least one selected from a communication module, a voice module (52), and an illumination module (53).

17. An autonomous mobile device, comprising: a main body housing (10) and at least one navigation apparatus according to any one of claims 1 to 16, the at least one navigation apparatus being arranged on the main body housing (10).

18. The autonomous mobile device according to claim 17, wherein
two navigation apparatuses are provided, and the two navigation apparatuses are symmetrically arranged on two sides of the main body housing (10).

19. The autonomous mobile device according to claim 17 or 18, wherein
at least one handle protrudes from a side wall of the main body housing (10), and the navigation apparatus is arranged on the corresponding handle.
